# EUROPÄISCHE PATENTSCHRIFT

(11) **EP 0 541 845 B1**
(45) Veröffentlichungstag und Bekanntmachung des Hinweises auf die Patenterteilung: **18.05.1994**
(21) Anmeldenummer: 91119252.4
(22) Anmeldetag: 12.11.1991
(51) Int. Cl.: B65G 47/14, B23P 19/00, H05K 13/02

(54) **Verfahren und Vorrichtung zum Zuführen von unsymmetrisch ausgebildeten Bauteilen für Montagezwecke, insbesondere zur Montage auf einen Werkstückträger**
Method and device for supplying asymmetrical parts to a workpiece holder
Méthode et dispositif pour amener de pièces asymmetriques à un porte-pièce

(43) Veröffentlichungstag der Anmeldung: 19.05.1993
(73) Patentinhaber: SIEMENS AKTIENGESELLSCHAFT, 80333 München (DE)
(72) Erfinder: Ebach, Herbert, Dr.-Ing., W-8505 Röthenbach a.d. Pegnitz (DE); Jaksch, Norbert, W-8508 Wendelstein (DE)

(56) Entgegenhaltungen:
- AT-A- 341 426
- DE-U- 8 911 221
- GB-A- 2 060 584
- GB-A- 2 198 344
- US-A- 4 362 236
- US-A- 4 995 157

## Beschreibung

Die Erfindung bezieht sich auf ein Verfahren zum Zuführen von unsymmetrisch ausgebildeten Bauteilen für Montagezwecke, insbesondere zur Montage auf einen Werkstückträger, wobei die Bauteile zunächst ungeordnet in einem Vorratsbehälter vorliegen und mittels Vielfachtechnik automatisiert geordnet werden. Daneben bezieht sich die Erfindung auch auf die zugehörige Vorrichtung mit einer Ordnungseinrichtung, mit der eine Vielzahl von unsymmetrisch ausgebildeten Bauteilen in vorgegebene Position bringbar ist.

In vielen Fällen müssen Teile, die ungeordnet als Schüttgut angeliefert sind, zunächst vereinzelt und geordnet werden. Häufig sollen diese Teile in genauer Position auf einem Werkstückträger montiert werden.

Bisher wurden solche Vorgänge im wesentlichen halbautomatisch durchgeführt. Dabei wurde bereits ausgenützt, daß gleiche Bauteile matrixartig geordnet werden können, wozu insbesondere das Prinzip der Vielfachhandhabung angewandt wird. Bei einem solchen Vielfachhandhabungsprinzip wird im allgemeinen ein Schüttvorrat von ungeordneten Teilen durch Rüttel- oder Schwingbewegung vereinzelt. Mittels Ordnungs- und Schiebeplatten mit vorgegebenen Matrizenprofilen lassen sich gleichermaßen einzelne Teile in vorgegebene Formnester einbringen und im geordneten Muster ablegen. Im so geordneten Zustand werden die Bauteile dann weiteren Bearbeitungsvorgängen zugeführt. Der Ordnungs- und Montagevorgang bildet dabei zwei jeweils abgeschlossene Verfahrensabschnitte.

Anordnungen zum Ordnen von Bauteilen durch Vielfachhandhabung sind beispielsweise aus der EP-A-0 360 872 und der US-A-4 829 748 bekannt. Insbesondere bei der EP-A-0 360 872 sollen Aufnahmespuren mit einer Vielzahl von vorgegebenen Formnestern vorhanden sein, in welche Bauteile durch gleichermaßen mittels eines Schwingungsgenerators durchzuführende Longitudinal- und Lateralbewegungen eingebracht werden. Bei der US-A-4 829 748 werden dagegen jeweils einzelne Platten mit Bauteilen bestückt. Über die weitere Verwendung der so geordneten Teile werden in beiden Fällen keine Aussagen gemacht.

Vom Stand der Technik sind Vorrichtungen zum Führen geometrisch einfacher Teile über Rüttelförderer in parallelen Spuren mit Linearförderern bekannt. Beispiele hierfür sind die US-A-4 995 157, die GB-A-21 98 344, die DE-U-8 911 221 und die US-A-4 362 236. Unterschiedlich ausgebildeteTeile sollen speziell in der GB-A-20 60 584 aus verschiedenen Fördergeräten zu einer Übergabestation geführt werden. Dafür ist eine optische Lageerkennung der Teile mit Referenzpunkten notwendig, wobei nach automatischem Entnehmen der Teile die Montage einzeln auf einem Werkstückträger erfolgen kann. Bei der AT-A-0 341 426 sollen speziell unsymmetrisch ausgebildete Teile zu einer Übergabestation geführt werden. Dazu fallen die Teile von einem Vorratsbehälter auf einen ersten Linearförderer und werden teilgerichtet. Auf einem anschließenden zweiten Linearförderer werden die Teile weiter ausgerichtet und Falschteile zurückgeführt. Diese Anordnung, bei der das Ordnen der Teile in mehreren Stufen mit Hilfe von Leitblechen, Abscheidern, Blasdüsen u. dgl. erfolgt, kann mit mehreren Spuren nebeneinander ausgebildet sein.

Aufgabe der Erfindung ist es demgegenüber, ein Verfahren und die zugehörige Vorrichtung anzugeben, mit denen in einem geschlossenen Verfahrensablauf insbesondere unsymmetrisch ausgebildete Bauteile automatisiert zugeführt und anschließend ggfs. auf Werkstückträger montiert werden können.

Die Aufgabe ist erfindungsgemäß mit folgenden Verfahrensschritten gelöst:
a1) Die Bauteile werden geometrisch ausgerichtet und
a2) in der gleichen geometrischen Ausrichtung geordnet in parallele Spuren eingebracht und darin fortlaufend vom Ort der geometrischen Ausrichtung fortgeführt,
b) in den Spuren wird der Teilevorrat an Bauteilen nahezu konstant gehalten,
c) am Ende der Spuren wird diskontinuierlich jeweils eine Anzahl von auf gleicher Förderhöhe befindlichen Teilen weggenommen
d) und dem Verwendungszweck zugeführt.

Vorzugsweise wird die Anzahl der auf gleicher Förderhöhe befindlichen Teile zur Montage auf einem Werkstückträger dem in geeignete Position gebrachten Werkstückträger zugeführt.

Ein solches erfindungsgemäßes Verfahren läßt sich in vorteilhafter Weise bei gleich ausgebildeten Bauteilen, die gemeinsam bzw. gruppenweise montiert werden sollen, anwenden. Dabei werden die Bauteile in im wesentlichen bekannter Weise durch Rüttel- bzw. Schwingbeaufschlagung in die einzelnen Spuren gebracht. Durch eine bewegbare Wippe können aus den Spuren jeweils die in einer Zeile parallel geordneten Bauteile freigegeben werden, so daß sie unmittelbar für den Montagevorgang zur Verfügung steht. Dabei ist wesentlich, daß nunmehr die bisher als separate Verfahrensabschnitte für sich abgeschlossenen Handhabungs- und Montagevorgänge vollständig vernetzt werden können.

In bevorzugter Ausführung des erfindungsgemäßen Verfahrens kann die Freigabe der Bauteile ohne Unterbrechung der Rüttel- bzw. Schwingbewegung erfolgen. Da die Montage der Bauteile in gewissem räumlichem Abstand erfolgt, ist es vorteilhaft, die geordneten Bauteile über Greifer, welche von der Rüttelbewegung unabhängig sind, zu Werkstückträgern zu führen.

Bei der zugehörigen Vorrichtung zur Durchführung des Verfahrens besteht die Ordnungseinrichtung erfindungsgemäß aus einer ersten Platte mit Formnestern zur geometrischen Ausrichtung der Bauteile und ist der ersten Platte wenigstens eine zweite Platte mit einer Vielzahl von in Längsrichtung der Platte ausgerichteten, durchlaufenden Nuten zugeordnet, wobei die erste Platte als Schüttelplatte für die ungeordneten Bauteile über der zweiten Platte als Förderplatte in die geordneten Bauteile angeordnet ist.

Vorteilhafterweise kann die Schüttelplatte einen Schiebeboden aufweisen und sich zwischen Schüttelplatte und Förderplatte zusätzlich eine Trichterplatte zur Drehung der Bauteile um 90° befinden. Damit können insbesondere flache unsymmetrisch ausgebildete Bauteile, die für die bestimmungsgemäße Anwendung auf den Schmalseiten dicht nebeneinander montiert werden müssen, ausgerichtet und geordnet werden.

Bei der erfindungsgemäßen Vorrichtung kann in bekannter Weise die Nutenplatte von einem Antrieb in uniaxiale Schwingungen zur Linearförderung der Bauteile versetzt werden. Mittels einer Wippe können Teile freigegeben werden. Dabei werden die freigegebenen Bauteile vom Greifer, vorzugsweise einem Sauggreifer aufgenommen. Insbesondere durch einen vakuumaktivierbaren Greifer ist es möglich, von der Anzahl der nebeneinanderliegenden Bauteile nur bestimmte Teile zu entnehmen, die für die spezifische Montage benötigt werden. Die nicht benötigten Bauteile werden dem Teilevorrat zurückgeführt und stehen für die Montage weiter zur Verfügung.

Das erfindungsgemäße Verfahren und die zugehörige Vorrichtung sind für alle Montageaufgaben einsetzbar, bei denen ungeordnet vorliegende, unsymmetrisch ausgebildete Bauteile im Muster montiert werden sollen. Es hat sich insbesondere bei der Vielfachmontage von Schalthebeln auf Kontaktsätzen für Programmschalter bewährt.

Weitere Einzelheiten und Vorteile der Erfindung ergeben sich aus der nachfolgenden Figurenbeschreibung eines Ausführungsbeispiels anhand der Zeichnung. Es zeigen
- Figur 1: eine Seitenansicht einer Vorrichtung zum Bestücken eines Programmschalters mit gleich ausgebildeten Schalthebeln,
- Figur 2: eine Draufsicht der Vorrichtung
- Figur 3: eine vergrößerte Darstellung des Funktionsbereiches aus Figur 1/2 in teilweise geschnittener Form und
- Figur 4: einen Ausschnitt aus der Greifvorrichtung in perspektivischer Darstellung.

Die Figuren werden im wesentlichen gemeinsam beschrieben. Anhand der Figurenbeschreibung ergibt sich bei der bestimmungsgemäßen Anwendung der Vorrichtung das beanspruchte Verfahren.

Mit der nachfolgend beschriebenen Vorrichtung sollen Schaltelemente für Programmschalter montiert werden, wie sie beispielsweise für Waschmaschinen oder dergleichen benötigt werden. Solche mechanischen Programmschalteinheiten weisen eine Mehrzahl von nebeneinanderliegenden Schalthebeln mit Nocken auf, wobei die Schalthebel für sich gesehen flache, unsymmetrisch ausgebildete Bauteile bilden.

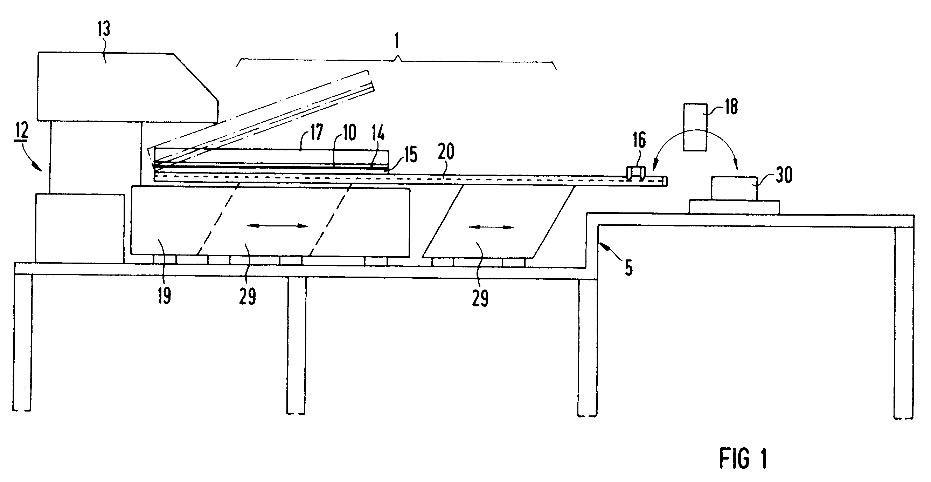

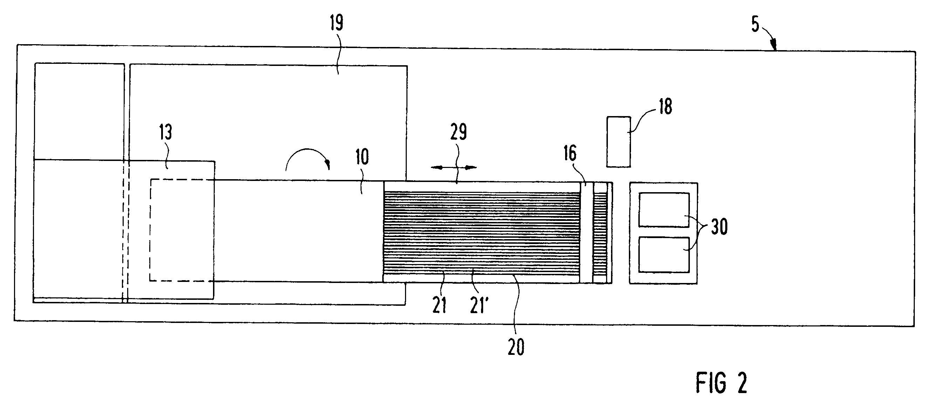

Die Vorrichtung gemäß Figur 1 und Figur 2 wird im wesentlichen aus einer Ordnungseinrichtung 1 auf einer Arbeitsplattform 5 gebildet. Sie besteht im einzelnen aus einer mit einer Rüttelbewegung beaufschlagbaren Ordnungsplatte 10 mit im Muster angeordneten Formnestern 11, 11',... und einer sogenannten Nutenplatte 20, d.h. einer Platte, in der in Längsrichtung parallele Spuren als Matrixform eingebracht sind und die in Längsrichtung mit Schwingungen beaufschlagbar ist. Es sind Nuten 21, 21',... mit beispielsweise 24 Spuren dargestellt. Erprobungen haben ergeben, daß bis 48 Spuren vorhanden sein können, ohne daß die Funktionsfähigkeit der Vorrichtung beeinflußt wird.

Am äußeren Ende der von einem Rahmen 17 umgebenen Ordnungsplatte 10 befindet sich eine Übergabestation 12 mit einer Schütteinrichtung 13 für einen Bauteilevorrat. Über eine entsprechende Schrägrutsche gelangen die Schaltelemente als unsymmetrisch ausgebildete Bauteile 100 ungeordnet auf die Ordnungsplatte 10 mit den Formnestern 11, 11',... . Durch die im wesentlichen flächenhaften Kreisschwingungen der Ordnungsplatte 10 werden die Bauteile aus dem geschütteten Zustand vereinzelt und entsprechend geometrisch ausgerichtet. In den einzelnen Formnestern 11, 11' liegen dann die Schaltelemente geordnet in gleicher geometrischer Ausrichtung entsprechend der Orientierung der Formnester 11, 11',... vor. Zweckmäßigerweise sind die aufeinanderfolgenden Reihen der Formnester gegeneinander um einen Abstand versetzt. Über einen Schiebeboden 14 läßt sich diese definierte Lage für den weiteren Handhabungsvorgang erhalten und auf eine zweite Platte 20 übertragen. In der zweiten Platte 20, der sogenannten Nutenplatte werden die auf Lücke stehenden, geometrisch gleich ausgerichteten Bauteile in die parallelen Spuren 21, 21',... der Nutenplatte 20 eingebracht und darin aneinandergereiht linear vorwärtsbewegt.

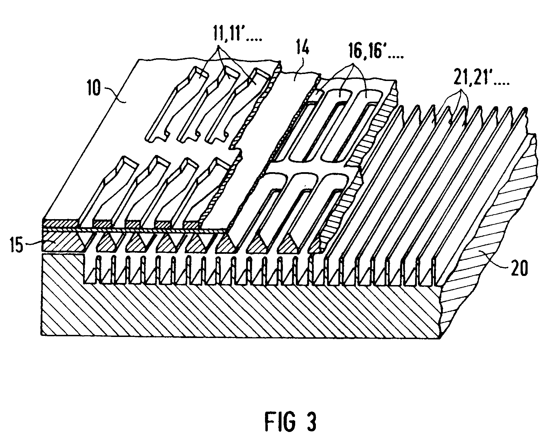

Gemäß Figur 2 und Figur 3 ist zwischen der Ordnungsplatte 10 und Nutenplatte 20 zusätzlich eine Trichterplatte 15 angeordnet, in der trichterförmige Aussparungen 16, 16',... im entsprechenden Muster vorhanden sind. Damit wird erreicht, daß die ausgerichteten Bauteile 100 beim Durchfallen um beispielsweise 90° um ihre Längsachse gedreht werden. Dies ist bei flach ausgebildeten Teilen dann erforderlich, sofern sie auf ihren Schmalseiten aufgerichtet montiert werden sollen.

Die Anordnung aus vom Rahmen 17 umgebener Ordnungsplatte 10 einschließlich Schiebeboden 14 und Trichterplatte 15 ist verschwenkbar, um nach dem Beschicken und Einordnen der Bauteile einen störenden Teileüberschuß zu entfernen. Nur ausgerichtete Bauteile werden in die Spuren der Nutenplatte 20 übertragen. Durch Schwingen der Nutenplatte 20 in Bezug auf die Längsrichtung des Aufbaus, ergibt sich eine Vorwärtsbewegung der Bauteile 100 in den einzelnen Nuten 21, 21',... , die im wesentlichen durch das Wegführen der Bauteile 100 im vorderen Bereich und den Nachschub der Bauteile 100 aus dem sogenannten Bandbunker 13 bestimmt wird. Insgesamt wird dabei in der Ordnungseinrichtung 1 der Teilevorrat nahezu konstant gehalten. Dafür sind ein Antrieb 19 für die Rüttelbewegung der Ordnungsplatte 10 und ein Antrieb 29 für die Linearförderung in der Nutenplatte 20 aufeinander abgestimmt.

Am Ende der Nutenplatte 20 ist eine Wippe 26 angebracht, mit der der Teilefluß gesperrt oder geöffnet werden kann. Durch Anheben der Wippe 26 wird jeweils zeilenweise die vorgegebene Anzahl von Bauteilen 100, 100'... zur Montage freigegeben, sofern ein Werkstückträger sich in geeigneter Montageposition befindet.

Zur Entnahme der geordneten Bauteile kann die Rüttelbewegung der Ordnungsplatte 10 und die Schwingbewegung der Nutenplatte 20 ausgesetzt werden. Bei einer geeignet ausgebildeten Vorrichtung kann jedoch die Entnahme der Bauteile auch bei Bewegung der Ordnungseinrichtung 1 erfolgen, wenn für eine definierte Wegführung der Bauteile 100 gesorgt ist.

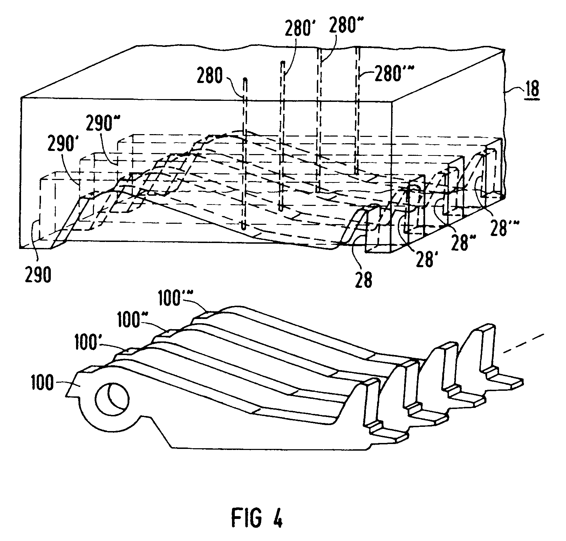

Bei der dargestellten Vorrichtung erfolgt die Wegführung der Bauteile 100 durch Entnahme mittels eines Sauggreifers 18 gemäß Figur 4, der separat aktivierbare Teilbereiche 28, 28',... hat. Dafür sind separate Vakuumanschlußleitungen 280, 280',... vorhanden, die in den parallelen Kanälen über Programm ansteuerbar sind. Zur besseren Trennung der Bauteile 100 und Aufrechterhaltung des vorgegebenen Rasters sind die Kanäle 28, 28',... des Greifers 18 durch Zwischenbleche 290, 290',... getrennt.

Statt vakuumaktivierbarer Sauggreifer können gleichermaßen auch programmierbare Magnetgreifer eingesetzt werden, sofern die Bauteile aus entsprechenden Materialien bestehen. Mit programmierbaren Greifern kann erreicht werden, daß im Rahmen einer flexiblen Fertigung für die Montage bestimmter Kontaktsätze als Werkstückträger 30 beispielsweise nur jedes zweite Schaltelement der Reihe entnommen und montiert wird. Die nicht entnommenen Bauteile werden dagegen freigegeben und in den Teilevorratsbehälter 13 zurückgeführt. Sie stehen dann für eine weitere Verarbeitung zur Verfügung.

Aus den Darstellungen der Funktionsteile ergibt sich insgesamt der vernetzte Arbeitsablauf bei einer integrierten Fertigung: Im vorgegebenen Takt sperrt die Wippe 26 bei Bedarf den Teilefluß ab und gibt die Teile zeilenweise dann zur Montage frei, wenn ein Kontaktsatz als Werkstückträger 30 in Position gebracht ist. Über die Kanäle 28, 28'... des Greifers 18 werden die benötigten Schalthebel 100, 100',... entnommen und im vorgegebenen Raster der feststehenden Montagestation mit dem Kontaktsatz zugeführt. Somit ist eine mit dem Ordnungsvorgang vernetzte Montage ohne manuellen Eingriff möglich.

Mit obiger Vorrichtung ist also gewährleistet, daß die definierte Anzahl von Bauteilen gleichzeitig gehandhabt werden kann und für den Montagevorgang zur Verfügung steht. Dazu werden Werkstückträger 30, 30'..., auf denen die Bauteile 100 montiert werden sollen, auf der Montageplattform 5 in die Arbeitsposition gebracht.

Das beschriebene Verfahren und die zugehörige Vorrichtung hat sich insbesondere bei der Bestückung von mechanischen Programmschaltern mit gleichen Kontakthebeln bewährt. Es ist aber auch für andere Fälle der Praxis anwendbar, bei denen Werkstückträger mit einer Vielzahl von im wesentlichen unsymmetrisch aufgebauten Bauteilen gleicher oder unterschiedlicher Art bestückt werden sollen.

## Patentansprüche

1. Verfahren zum Zuführen von unsymmetrisch ausgebildeten Bauteilen (100) für Montagezwecke, insbesondere zur Montage auf einem Werkstückträger, wobei die Bauteile zunächst ungeordnet in einem Vorratsbehälter (13) vorliegen und mittels Vielfachtechnik automatisiert geordnet werden, mit folgenden Verfahrensschritten:
a1) die Bauteile werden geometrisch ausgerichtet und
a2) in der gleichen geometrischen Ausrichtunq geordnet in parallel Spuren (21,21',...) eingebracht und darin fortlaufend vom Ort der geometrischen Ausrichtung fortgeführt,
b) in den Spuren wird der Teilevorrat an Bauteilen nahezu konstant gehalten,
c) am Ende der Spuren wird diskontinuierlich jeweils eine Anzahl von auf gleicher Förderhöhe befindlichen Teilen weggenommen
d) und dem Verwendungszweck zugeführt.

2. Verfahren nach Anspruch 1, **dadurch** **ge****kennzeichnet**, daß zur Montage auf einem Werkstückträger eine Anzahl der auf gleicher Förderhöhe befindlichen Teile dem in geeignete Position gebrachten Werkstückträger zugeführt wird.

3. Verfahren nach Anspruch 1, **dadurch gekennzeichnet**, daß es für gleich ausgebildete Bauteile ausgeführt wird.

4. Verfahren nach Anspruch 1, **dadurch ge****kennzeichnet**, daß die Bauteile durch Rüttel- bzw. Schwingbeaufschlagung ausgerichtet werden.

5. Verfahren nach Anspruch 1, **dadurch gekennzeichnet**, daß die ausgerichteten Bauteile in die Spuren übergeben werden und in den Spuren geordnet durch Schwingbeaufschlagung linear fortbewegt werden.

6. Verfahren nach Anspruch 1, **dadurch gekennzeichnet**, daß die ausgerichteten Bauteile beim Einbringen in die Spuren um einen Winkel bezüglich ihrer Längsachse gedreht werden.

7. Verfahren nach Anspruch 1, **dadurch gekennzeichnet**, daß am Ende der Spuren mittels einer bewegbaren Wippe die vorgegebene Anzahl parallel geordneter Bauteile freigegeben wird.

8. Verfahren nach Anspruch 2, **dadurch gekennzeichnet**, daß mittels eines Greifers die vorgegebene Anzahl parallel orientierter Bauteile zur Montage auf den Werkstückträger weggeführt werden.

9. Verfahren nach Anspruch 8, **dadurch ge****kennzeichnet**, daß vom Greifer aus der Anzahl parallel geordneter Bauteile jeweils nur aus bestimmten Spuren entnommen werden.

10. Verfahren nach Anspruch 9, **dadurch gekennzeichnet**, daß die Entnahme aus bestimmten Spuren programmiert erfolgt.

11. Verfahren nach einem der Ansprüche 7 bis 10, **dadurch gekennzeichnet**, daß Freigabe und Wegführung der Bauteile ohne Unterbrechung der Schwingbewegung erfolgt.

12. Vorrichtung zur Durchführung des Verfahrens nach Anspruch 1 oder einem der Ansprüche 2 bis 11 mit einer Vorratseinrichtung (13) für die Bauteile (100,100',...) und einer nachfolgenden Ordnungseinrichtung, mit der eine Vielzahl von unsymmetrisch ausgebildeten Bauteilen in definierter Ausrichtung in vorgegebene Position bringbar ist, **dadurch gekennzeichnet**, daß die Ordnungseinrichtung aus einer ersten Platte (10) mit Formnestern (11, 11',...) zur geometrischen Ausrichtung der Bauteile (100) besteht und daß der ersten Platte (10) wenigstens eine zweite Platte (20) mit einer Vielzahl von in Längsrichtung der Platte (20) ausgerichteten, durchlaufenden Nuten (21, 21',...) zugeordnet ist, wobei die erste Platte (10) als Ordnungsplatte für die ungeordneten Bauteile (100) über der zweiten Platte (20) als Förderplatte für die geordneten Bauteile (100) angeordnet ist.

13. Vorrichtung nach Anspruch 12, **dadurch gekennzeichnet**, daß die Ordnungsplatte (10) einen Schiebeboden (14) aufweist.

14. Vorrichtung nach Anspruch 12, **dadurch ge****kennzeichnet**, daß sich wischen Ordnungsplatte (10) und Förderplatte (20) eine Trichterplatte (15) zur Drehung der Bauteile (100) um 90° befindet.

15. Vorrichtung nach Anspruch 12 oder 13, **dadurch** **gekennzeichnet**, daß Ordnungsplatte (10) und Förderplatte (20) von je einem eigenen Antrieb (19, 29) in Schwingungen versetzbar sind.

16. Vorrichtung nach Anspruch 15, **dadurch gekennzeichnet**, daß die Antriebe (19, 29) beider Platten (10, 20) aufeinander abgestimmt sind.

17. Vorrichtung nach Anspruch 15 oder 16, **dadurch gekennzeichnet**, daß die Ordnungsplatte (10) eine flächenhafte Kreisschwingung und die Förderplatte (20) eine Linearschwingung ausführt.

18. Vorrichtung nach Anspruch 12, **dadurch ge****kennzeichnet**, daß am Ende der Förderplatte (20) eine in die Nuten (21, 21',...) eingreifende Wippe (16) kippbar angeordnet ist.

19. Vorrichtung nach Anspruch 12, **dadurch ge****kennzeichnet,** daß ein Greifer (18) zur Entnahme der Bauteile (100) vorhanden ist.

20. Vorrichtung nach Anspruch 19, **dadurch ge****kennzeichnet**, daß der Greifer (18) ein Vakuumgreifer ist.

21. Vorrichtung nach Anspruch 19, **dadurch ge****kennzeichnet**, daß der Greifer (18) eine der vorgegebenen Anzahl der Bauteile (100) entsprechende Anzahl von Kanälen (28, 28',...) aufweist und daß die einzelnen Kanäle (28, 28',...) separat aktivierbar sind.

## Claims

1. Method for the supply of asymmetrically formed components (100) for assembly purposes, in particular for assembly on a work piece carrier, with the components first of all being present in a disordered state in a supply container (13) and being ordered in an automated manner by means of multiple technology, having the following method steps:
a1) the components are aligned geometrically and,
a2) ordered in the same geometrical alignment, are introduced into parallel tracks (21, 21',...) and therein are continuously conveyed from the place of geometrical alignment,
b) the parts-supply of components is kept almost constant in the tracks,
c) at the end of the tracks at any given time a quantity of parts located at the same conveying level is removed discontinuously
d) and is supplied to the intended application.

2. Method according to claim 1, characterised in that for the purpose of assembly on a work piece carrier a quantity of the parts located at the same conveying level is supplied to the work piece carrier which has been brought into a suitable position.

3. Method according to claim 1, characterised in that it is designed for components which are formed in an identical manner.

4. Method according to claim 1, characterised in that the components are aligned by shaking and application of vibration.

5. Method according to claim 1, characterised in that the aligned components are delivered into the tracks and, ordered in the tracks, are moved on in a linear fashion by application of vibration.

6. Method according to claim 1, characterised in that the aligned components are turned through an angle relative to their longitudinal axis when introduced into the tracks.

7. Method according to claim 1, characterised in that the given quantity of components which are ordered in parallel is released at the end of the tracks by means of a movable rocker.

8. Method according to claim 2, characterised in that the given quantity of components which are orientated in parallel are guided away by means of a gripper, for assembly on the work piece carrier.

9. Method according to claim 8, characterised in that in each case the gripper only takes from certain tracks when taking from the quantity of components which are ordered in parallel.

10. Method according to claim 9, characterised in that the removal from certain tracks is effected in a programmed manner.

11. Method according to one of the claims 7 to 10, characterised in that the release and guidance of the components away is effected without interruption of the vibrating motion.

12. Arrangement for carrying out the method according to claim 1 or one of the claims 2 to 11, having a supply device (13) for the components (100, 100',...) and a downstream ordering device with which a plurality of asymmetrically formed components can be brought into a given position in defined alignment, characterised in that the ordering device consists of a first plate (10) with shaped nests (11, 11',...) for the geometrical alignment of the components (100) and in that at least one second plate (20) having a plurality of continuous grooves (21, 21'...), which are aligned in the longitudinal direction of the plate (20), is associated with the first plate (10), wherein the first plate (10) is arranged as an ordering plate for the disordered components (100) over the second plate (20) as a conveyor plate for the ordered components (100).

13. Arrangement according to claim 12, characterised in that the ordering plate (10) has a sliding base (14).

14. Arrangement according to claim 12, characterised in that a funnel plate (15) is located between ordering plate (10) and conveyor plate (20) for turning the components (100) through 90°.

15. Arrangement according to claim 12 or 13, characterised in that ordering plate (10) and conveyor plate (20) can each be set vibrating by a respective drive (19, 29).

16. Arrangement according to claim 15, characterised in that the drives (19, 29) of both plates (10, 20) are matched to each other.

17. Arrangement according to claim 15 or 16, characterised in that the ordering plate (10) effects a circular vibration on the surface and the conveyor plate (20) effects a linear vibration.

18. Arrangement according to claim 12, characterised in that a rocker (16) engaging into the grooves (21, 21',...) is arranged in a tiltable manner at the end of the conveyor plate (20).

19. Arrangement according to claim 12, characterised in that a gripper (18) is provided for the removal of the components (100).

20. Arrangement according to claim 19, characterised in that the gripper (18) is a vacuum gripper.

21. Arrangement according to claim 19, characterised in that the gripper (18) has a number of channels (28, 28',...) corresponding to the given number of components (100) and in that the individual channels (28, 28',...) can be activated separately.

## Revendications

1. Procédé d'amenage de pièces constitutives (100) non symétriques en vue de leur montage, destiné notamment au montage sur un support de pièce à usiner, les pièces constitutives étant d'abord disposées en désordre dans un récipient de réserve (13) puis étant disposées en ordre de façon automatisée, en ayant recours à plusieurs techniques, comportant les étapes de procédé suivantes :
a1) les pièces constitutives sont alignées géométriquement et,
a2) sont placées dans des pistes (21, 21', ...) parallèles en étant disposées dans le même alignement géométrique et elles y sont guidées en continu à partir du lieu d'alignement géométrique,
b) la réserve de pièces constitutives présente dans les pistes est maintenue approximativement constante,
c) à l'extrémité des pistes s'opère de façon discontinue, dans chaque cas, un prélèvement d'un certain nombre de pièces qui se trouvent à la même hauteur de transport,
d) et ces pièces sont amenées à leur lieu d'utilisation.

2. Procédé selon la revendication 1, caractérisé en ce qu'en vue du montage sur un support de pièce à usiner un certain nombre des pièces qui se trouvent à la même hauteur de transport sont amenées au support de pièce à usiner mis dans la position appropriée.

3. Procédé selon la revendication, caractérisé en ce qu'il est pratiqué sur des pièces de forme identique.

4. Procédé selon la revendication 1, caractérisé en ce que les pièces constitutives sont alignées en étant soumises à des secousses, ou à des vibrations.

5. Procédé selon la revendication 1, caractérisé en ce que les pièces constitutives alignées sont transférées dans les pistes et déplacées linéairement au moyen de vibrations en étant disposées en ordre dans les pistes.

6. Procédé selon la revendication 1, caractérisé en ce que les pièces constitutives alignées sont tournées d'un certain angle par rapport à leur axe longitudinal lors de leur mise en place dans les pistes.

7. Procédé selon la revendication 1, caractérisé en ce que les pièces constitutives disposées parallèlement, dont le nombre a été fixé à l'avance, sont libérées à l'extrémité des pistes au moyen d'un basculeur mobile.

8. Procédé selon la revendication 2, caractérisé en ce que les pièces constitutives orientées parallèlement, dont le nombre a été fixé à l'avance, sont évacuées au moyen d'un organe de saisie en vue du montage sur le support de pièce à usiner.

9. Procédé selon la revendication 8, caractérisé en ce que de la quantité de pièces constitutives disposées parallèlement des pièces ne sont prélevées qu'à partir de pistes déterminées.

10. Procédé selon la revendication 9, caractérisé en ce que le prélèvement à partir de pistes déterminées est effectué selon un programme.

11. Procédé selon l'une des revendications 7 à 10, caractérisé en ce que la libération et l'enlèvement des pièces constitutives s'effec- tue sans interruption du mouvement vibratoire.

12. Dispositif pour la mise en oeuvre du procédé selon la revendication 1 ou selon l'une des revendications 2 à 11, comportant un dispositif de réserve (13) pour les pièces constitutives (100, 100', ...) et un dispositif de mise en ordre qui suit, au moyen duquel un grand nombre de pièces constitutives de forme non symétrique peuvent être mises dans un alignement défini, dans une position fixée à l'avance, caractérisé en ce que le dispositif de mise en ordre est constitué d'un premier plateau (10) comportant des logements d'une certaine forme (11, 11', ...) destinés à l'alignement géométrique des pièces constitutives (100) et qu'au premier plateau (10) est associé au moins un second plateau (20) comportant un grand nombre de gorges (21, 21', ...) traversantes alignées dans le sens longitudinal du plateau (20), le premier plateau (10) étant en tant que plateau de mise en ordre des pièces constitutives (100) se présentant en désordre, au-dessus du deuxième plateau (20) servant de plateau de transport des pièces constitutives (100) ordonnées.

13. Dispositif selon la revendication 12, caractérisé en ce que le plateau de mise en ordre (10) présente un fond coulissant (14).

14. Dispositif selon la revendication 12, caractérisé en ce qu'entre le plateau de mise en ordre (10) et le plateau de transport (20) se trouve un plateau servant de trémie (15) destinée à faire tourner les pièces constitutives (100) de 90°.

15. Dispositif selon la revendication 12 ou 13, caractérisé en ce que le plateau de mise en ordre (10) et le plateau de transport (20) peuvent être mises en vibration au moyen d'un entraînement (19, 29) propre à chacune d'elles.

16. Dispositif selon la revendication 15, caractérisé en ce que les entraînements (19, 29) des deux plateaux (10, 20) sont coordonnés l'un à l'autre.

17. Dispositif selon la revendication 15 ou 16, caractérisé en ce que le plateau de mise en ordre (10) exécute une vibration circulaire de surface et le plateau de transport (20) une vibration linéaire.

18. Dispositif selon la revendication 12, caractérisé en ce qu'à l'extrémité de le plateau (20) un basculeur pénétrant dans les gorges (21, 21') est monté de façon basculante.

19. Dispositif selon la revendication 12, caractérisé en ce qu'un organe de préhension (18) est présent en vue de l'enlèvement des pièces constitutives (100).

20. Dispositif selon la revendication 19, caractérisé en ce que l'organe de préhension (18) est un organe de préhension à dépression.

21. Dispositif selon la revendication 19, caractérisé en ce que l'organe de préhension (18) comporte un nombre de canaux (28, 28') correspondant au nombre fixé à l'avance de pièces constitutives et les canaux (28, 28'...) individuels peuvent être mis en action séparément.
